# EUROPÄISCHE PATENTSCHRIFT

(11) **EP 1 575 169 B1**
(45) Veröffentlichungstag und Bekanntmachung des Hinweises auf die Patenterteilung: **18.04.2018**
(21) Anmeldenummer: 05003828.0
(22) Anmeldetag: 23.02.2005
(51) Int. Cl.: H03K 17/945, G06F 3/00

(54) **Bildverarbeitender Näherungsschalter**
Proximity switch with signal processing system
Commutateur de proximité avec système de traitement d'image

(30) Priorität: 10.03.2004 DE 102004011642
(43) Veröffentlichungstag der Anmeldung: 14.09.2005
(73) Patentinhaber: ABB AG, 68309 Mannheim (DE)
(72) Erfinder: Tidden, Matthias, Dipl.-Ing., 58300 Wetter (DE); Jeide, Andreas, Dipl.-Ing., 58769 Nachrodt (DE); Riewe, Jens, Dipl.-Betriebswirt, 58509 Lüdenscheid (DE); Simon, Mirko, Dipl.-Ing., 58533 Halver (DE); Ulbrich, Steffan, Dipl.-Ing., 58579 Schalksmühle (DE); Zapp, Robert, Dipl.-Ing., 58579 Schalksmühle (DE); Goldyn, Dirk, Dipl.-Ing., 58454 Witten (DE)

(56) Entgegenhaltungen:
- WO-A-02/01336
- DE-A1- 19 809 210
- US-A1- 2002 036 617
- US-A1- 2002 150 278
- PATENT ABSTRACTS OF JAPAN Bd. 2002, Nr. 12, 12. Dezember 2002 (2002-12-12) & JP 2002 236534 A (MITSUBISHI MOTORS CORP), 23. August 2002 (2002-08-23)

## Beschreibung

Die Erfindung bezieht sich auf einen bildverarbeitenden Schalter gemäß dem Oberbegriff des Anspruchs 1. Die Erfindung kann beispielsweise für Schalter, Jalousieschalter und Dimmer verwendet werden.

Es sind Bewegungsmelder allgemein bekannt, die infolge detektierter, von Personen verursachter Wärmestrahlung Schalthandlungen ausführen, insbesondere Licht schalten. Hierbei wird zur Detektion einer Bewegung oder eines Abbildes ausschließlich Wärmestrahlung herangezogen. Andere allgemein bekannte bewegungserkennende Schalter arbeiten nach dem Radarprinzip. Weiterhin sind Schalter allgemein bekannt, die auf menschliche Sprache reagieren und derart Schalthandlungen auslösen. Solche Schalter haben gute Erkennungseigenschaften und müssen nicht mehr trainiert zu werden. Alle diese Schalter verfolgen den Zweck, mit einem größtmöglichen Komfort das Licht oder andere elektrische Geräte zu schalten.

Bei Bewegungsmeldern ist es von Nachteil, dass eine Schalthandlung nicht nur von einem Menschen, sondern auch von einem Tier oder allgemein von einer bewegten Wärmequelle ausgelöst wird. Ein gezieltes Ansprechen unterschiedlicher elektrischer Verbraucher innerhalb eines Erfassungsbereichs ist mit Bewegungsmeldern nicht möglich.

Aus der DE 198 09 210 A1 sind ein Verfahren und eine Vorrichtung zur automatisierten Überwachung einer Szene einem Kfz oder einer Fertigungstrasse, bekannt, wobei die Szene mit einer Lichtquelle beleuchtet und von einer Kamera aufgenommen wird. Diese Aufnahme wird mit einem Referenzbild derart verglichen, dass eine Abweichung zwischen Aufnahme und Referenzbild bestimmt, bewertet und eine vorgegebene Aktion, wie eine Alarmauslösung oder Notbremsung eines Fahrzeugs ausgelöst wird, sobald die Abweichung oberhalb eines vorgegebenen Schwellwerts liegt.

Schalter mit einer Spracheingabe erlauben zwar die gezielte Ansprache unterschiedlicher zu schaltender Verbraucher, sind jedoch in ihrer Handhabung relativ schwierig. Die den einzelnen unterschiedlichen Verbrauchern zugewiesenen Namen bzw. Begriffe müssen behalten und sehr korrekt ausgesprochen werden. Personen, denen diese Begriffe nicht bekannt sind, können diese Schalter auch nicht bedienen.

Der Erfindung liegt die Aufgabe zugrunde, einen bildverarbeitenden Schalter der eingangs genannten Art anzugeben, mit dem eine sehr einfache und eindeutige Zuordnung zu einem elektrischen Verbrauchern möglich ist.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, dass ein sehr komfortabler automatischer Schalter zur Schaltung von Licht oder anderer elektrischer Geräte geschaffen wird, welcher eine einfache Handhabung ohne weitere Hilfsmittel ermöglicht. Es muss lediglich eine Hand, gegebenenfalls mit ausgestrecktem Finger, vor eine an einer Wand gekennzeichnete Fläche gebracht werden. Hierbei ist es nicht erforderlich, die Wand zu berühren. Die Erkennung des Abbildes vor der gekennzeichneten Fläche erfolgt über mindestens eine auf die gekennzeichnete Fläche fokussierte Kamera. Diese Kamera kann je nach Anwendung im sichtbaren und/oder unsichtbaren (infraroten) Licht arbeiten. Eine Auswertelogik prüft nun den an der Wand kenntlich gemachten Bereich auf das Vorhandensein einer zeigenden Hand. Hierbei können neben der Form des Abbildes auch die Temperatur und/oder die Farbe des Abbildes als zusätzliche Erkennungsmerkmale dienen. Das digitalisierte Bild der Kamera durchläuft entsprechende Filter für Form und/oder Temperatur und/oder Farbe. Bei positivem Vergleich wird ein gewünschter Schaltvorgang ausgelöst. Dieser Schaltvorgang kann beliebiger Art sein:
- Ein- bzw. Ausschalten eines elektrischen Verbrauchers
- Dimmen einer Beleuchtung bei längerer Verweildauer der Hand im Erfassungsbereich.

Da mittels der gekennzeichneten Fläche genau vorgegeben ist, wo eine Hand kurzzeitig zu sein hat, um ein Schalten eines elektrischen Verbrauchers auszulösen, ist auch ungeübten und fremden Personen eine Bedienung des vorgeschlagenen bildverarbeitenden Schalters möglich. Besonders vorteilhaft kann ein solcher bildverarbeitender Schalter auch an Glaswänden realisiert werden, da keine (weder elektrische noch mechanische) Bauelemente in das Glas eingelassen werden müssen.

Weitere Vorteile sind aus der nachstehenden Beschreibung ersichtlich.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:

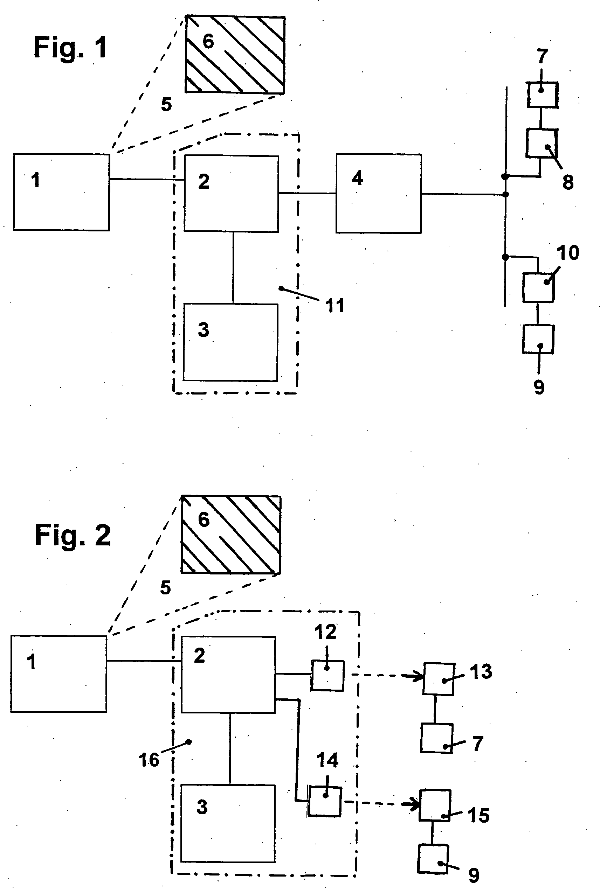

- Fig.1, 2, 3: einen bildverarbeitenden Schalter in drei unterschiedlichen Ausführungsformen.

In Fig. 1 ist ein bildverarbeitender Schalter gemäß einer ersten Ausführungsform dargestellt. Es ist ein Auswerteschaltkreis (mit Mikrocontroller) 2 zu erkennen, welcher eingangsseitig Signale einer Kamera 1 empfängt. Der Auswerteschaltkreis 2 ist mit einem Referenzspeicher 3 verbunden und sendet gegebenenfalls Ausgangssignale an ein Bussystem 4, welches mit einer Vielzahl von Verbrauchern sowie (nicht dargestellten) Sensoren und Betätigungseinheiten verbunden ist. Im Ausführungsbeispiel sind ein erster, über eine Ansteuervorrichtung 8 beaufschlagter elektrischer Verbraucher 7 sowie ein zweiter, über eine Ansteuervorrichtung 10 beaufschlagter elektrischer Verbraucher 9 dargestellt.

In diesem Zusammenhang sind Kameras interessant, welche für sichtbares Licht und/oder für Infrarotstrahlung sensibel sind. Mit einer Infrarot-Kamera wird die Wärmestrahlung eines Menschen bzw. einer menschlichen Hand erkennbar und folglich sind Gestiken dieses Menschen auch in einem völlig dunklen Raum erkennbar und auswertbar.

Die Kamera 1 ist beispielsweise an der Decke eines Raumes montiert und überwacht eine an einer Wand gekennzeichnete Fläche 6. Durch Verwendung eines entsprechend ausgelegten Objektivs ergibt sich ein auf diese gekennzeichnete Fläche 6 fokussierter Kamera-Erfassungsbereich 5. Der Auswerteschaltkreis 2 bewertet die von der Kamera 1 erhaltenen Informationen betreffend die an der gekennzeichneten Fläche 6 erfassten Abbilder im Hinblick auf im Referenzspeicher 3 abgelegte Abbilder. Ein typisches Beispiele für ein derartiges Abbild (Gestik) ist insbesondere eine kurzzeitig vor der gekennzeichneten Fläche präsente Hand mit ausgestrecktem Finger. Wie eingangs bereits erwähnt, kann die Verweildauer des detektierten Abbildes als Kriterium für die auszuführende Schalthandlung dienen, wie z. B. Ein-/Aus-Schalten bei kurzer Verweildauer / Dimmen bei längerer Verweildauer.

Es können auch mehrere Flächen 6 nebeneinander oder übereinander gekennzeichnet werden, um beispielsweise Beleuchtungen, Jalousien, Heizungen oder elektrische Geräte wie Radiogerät oder Fernsehgerät über die entsprechende Aktorik zu bedienen.

Selbstverständlich weisen Auswerteschaltkreis 2 und Referenzspeicher 3 eine entsprechende Erkennungs- und Auswertesoftware auf.

Weisen erfasste Abbilder eine große Ähnlichkeit mit abgespeicherten Abbildern auf, so steuert der Auswerteschaltkreis 2 den entsprechenden Verbraucher 7 oder 9 an, so dass beispielsweise das Licht der Deckenleuchte eingeschaltet oder die Jalousie geschlossen wird. Bei der Ausführungsform gemäß Fig. 1 ist der Auswerteschaltkreis 2 mit dem Bussystem 4 des Hauses verbunden und führt diesem den zur Ansteuerung des elektrischen Gerätes erforderlichen Steuerbefehl zu.

Zweckmäßig sind beim Beispiel nach Fig. 1 Auswerteschaltkreis 2 und Referenzspeicher 3 in einer Erfassungseinheit 11 (mit einem Gehäuse) integriert.

In Fig. 2 ist ein bildverarbeitender Schalter gemäß einer zweiten Ausführungsform dargestellt. Die Konfiguration mit Auswerteschaltkreis 2, Referenzspeicher 3 und Kamera 1 ist wie unter Fig. 1 beschrieben. Im Unterschied zur Ausführungsform gemäß Fig. 1 beaufschlagt der Auswerteschaltkreis 2 in Abhängigkeit eines bestimmten erkannten Abbildes einen (ersten) Infrarotsender 12, oder einen zweiten Infrarotsender 14 bzw. allgemein Sendeeinheiten 12, 14. Der Infrarotsender 12 strahlt Signale in Richtung einer Ansteuervorrichtung 13 mit Infrarot-Empfänger (allgemein Empfangseinheit), an welche ein erster Verbraucher 7 angeschlossen ist. Der Infrarotsender 14 strahlt Signale in Richtung einer Ansteuervorrichtung 15 mit Infrarot-Empfänger (allgemein Empfangseinheit), an welche ein zweiter Verbraucher 9 angeschlossen ist. Selbstverständlich können noch weitere Infrarotsender (zur Beaufschlagung weiterer Ansteuervorrichtungen mit daran angeschlossenen Verbrauchern mit dem Auswerteschaltkreis 2 verbunden sein.

Selbstverständlich kann die vorstehend angesprochene drahtlose Signalübertragung auch auf andere Weise, beispielsweise per Funk erfolgen. Zweckmäßig sind beim Beispiel gemäß Fig. 2 Auswerteschaltkreis 2, Referenzspeicher 3 und Infrarotsender 12, 14 (bzw. Funksender) in einer Erfassungseinheit 16 (mit einem Gehäuse) integriert, wobei die Infrarotsender einstellbar arretiert sind, um die präzise Einstellung bzw. Ausrichtung zum korrespondierenden Empfänger des Verbrauchers vornehmen zu können.

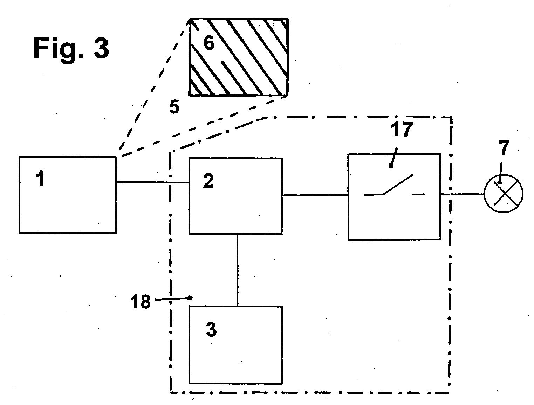

In Fig. 3 ist ein bildverarbeitender Schalter gemäß einer dritten Ausführungsform dargestellt. Die Konfiguration mit Auswerteschaltkreis 2, Referenzspeicher 3 und Kamera 1 ist wie unter Fig. 1 beschrieben. Im Unterschied zur Ausführungsform gemäß Fig. 1 beaufschlagt der Auswerteschaltkreis 2 direkt eine Lastschaltstufe 17, welche einen Verbraucher 7 ansteuert. Zweckmäßig sind beim Beispiel gemäß Fig. 3 Auswerteschaltkreis 2, Referenzspeicher 3 und Lastschaltstufe 17 in einer Erfassungseinheit 18 integriert. Darüber hinaus ist es auch möglich, die Kamera 1 zusätzlich in die Erfassungseinheit 18 einzubauen. Alternativ ist es möglich, den Verbraucher 7 und die Erfassungseinheit 18 zusammenzufassen.

Die einfachste Ausführungsform besteht darin, die Erfassungseinheit 18 zusammen mit der Kamera 1 in das Gehäuse des Verbrauchers 7 einzubauen. Auf diese Weise ist beispielsweise eine Deckenleuchte realisierbar, welche allein durch entsprechende Gestik vor der definierten Fläche 6 geschaltet wird.

### Bezugszeichenliste:

- 1: Kamera
- 2: Auswerteschaltkreis mit Mikrocontroller
- 3: Referenzspeicher
- 4: Bussystem
- 5: Kamera-Erfassungsbereich
- 6: (an einer Wand) gekennzeichnete Fläche
- 7: erster elektrischer Verbraucher
- 8: Ansteuervorrichtung
- 9: zweiter elektrischer Verbraucher
- 10: Ansteuervorrichtung
- 11: Erfassungseinheit
- 12: erster Infrarotsender, allgemein Sendeeinheit
- 13: Ansteuervorrichtung mit Empfangseinheit (Infrarot-Empfänger)
- 14: zweiter Infrarotsender, allgemein Sendeeinheit
- 15: Ansteuervorrichtung mit Empfangseinheit (Infrarot-Empfänger)
- 16: Erfassungseinheit
- 17: Lastschaltstufe
- 18: Erfassungseinheit

## Patentansprüche

1. Bildverarbeitender Schalter,
• mit einem Auswerteschaltkreis (2), welcher eingangsseitig mit mindestens einer Abbilder an einer an einer Wand gekennzeichneten Fläche (6) detektierenden Infrarotkamera (1) verbunden ist, welcher mit einem Referenzspeicher (3) verbunden ist, in dem mindestens ein bestimmtes, offline festgelegtes Abbild abgespeichert ist, und welcher ausgangsseitig mindestens einen elektrischen Verbraucher (7, 9) über ein Bussystem (4) beaufschlagt,
• wobei ein Vergleich zwischen aktuell detektiertem Abbild und abgespeichertem Abbild erfolgt und
• wobei der Verbraucher (7, 9) eine Schalthandlung auslöst, wenn der Auswerteschaltkreis (2) eine signifikante Ähnlichkeit zwischen aktuell detektiertem Abbild und abgespeichertem Abbild feststellt, **dadurch gekennzeichnet, dass** die Verweildauer des detektierten Abbildes das Kriterium für die auszuführende Schalthandlung derart ist, dass ein Ein-/Aus-Schalten eines elektrischen Verbrauchers bei kurzer Verweildauer des detektierten Abbildes und ein Dimmen einer Beleuchtung bei längerer Verweildauer des detektierten Abbildes bewirkt.

2. Bildverarbeitender Schalter nach Anspruch 1, wobei dass Auswerteschaltkreis (2) und Referenzspeicher (3) in einer Erfassungseinheit (11) integriert sind.

3. Bildverarbeitender Schalter nach Anspruch 1 oder 2, wobei dass außer der Form auch die Temperatur des Abbildes als Erkennungsmerkmal dient.

4. Bildverarbeitender Schalter nach einem der vorstehenden Ansprüche, wobei dass außer der Form auch die Farbe des Abbildes als Erkennungsmerkmal dient.

## Claims

1. Image-processing switch, having
• an evaluation circuit (2) which is connected on the input side to at least one infrared camera (1) which detects images on an area (6) marked on a wall, which is connected to a reference memory (3) in which at least one specific off-line defined image is stored, and which acts on the output side of at least one electrical load (7, 9) via a bus system (4),
• wherein a comparison is carried out between a currently detected image and a stored image, and
• wherein the load (7, 9) initiates a switching operation when the evaluation circuit (2) finds significant similarity between the currently detected image and the stored image,
• **characterized in that** the presence duration of the detected image is the criteria for the switching operation to be carried out in such a way as to bring about switching on/off of an electrical load for a short presence duration of the detected image and dimming of illumination for a longer presence duration of the detected image.

2. Image-processing switch according to Claim 1, wherein the evaluation circuit (2) and the reference memory (3) are integrated in a recording unit (11).

3. Image-processing switch according to Claim 1 or 2, wherein, apart from the shape, the temperature of the image is also used as an identification feature.

4. Image-processing switch according to one of the preceding claims, wherein, apart from the shape, the colour of the image is also used as an identification feature.

## Revendications

1. Commutateur de traitement d'image,
• comportant un circuit d'évaluation (2) qui est relié côté entrée à au moins un dispositif de formation d'image ayant une caméra infrarouge (1) qui détecte une surface (6) identifiée sur un mur et qui est relié côté sortie à une mémoire de référence (3) dans laquelle est stockée au moins une image spécifique définie hors ligne et qui attaque au moins une charge électrique (7, 9) par l'intermédiaire d'un système de bus (4),
• dans lequel une comparaison est effectuée entre l'image actuellement détectée et l'image stockée et
• dans lequel la charge (7, 9) déclenche une action de commutation lorsque le circuit d'évaluation (2) détecte une ressemblance significative entre l'image actuellement détectée et l'image stockée, **caractérisé en ce que**
• le temps d'arrêt de l'image détectée est le critère pour l'action de commutation à effectuer de manière à ce que cela provoque la mise en marche/l'arrêt d'une charge électrique avec un court temps d'arrêt de l'image détectée et une atténuation de l'éclairage avec un temps d'arrêt plus long de l'image détectée.

2. Commutateur de traitement d'images selon la revendication 1, dans lequel le circuit d'évaluation (2) et la mémoire de référence (3) sont intégrés dans une unité de détection (11).

3. Commutateur de traitement d'image selon la revendication 1 ou 2, dans lequel la température de l'image sert de caractéristique distinctive en plus de la forme.

4. Commutateur de traitement d'image selon l'une des revendications précédentes, dans lequel la couleur de l'image sert également de caractéristique distinctive en plus de la forme.
